# EUROPEAN PATENT APPLICATION

(11) **EP 4 283 664 A1**
(43) Date of publication of application: **29.11.2023**
(21) Application number: 23168683.3
(22) Date of filing: 19.04.2023
(51) Int. Cl.: H01L 23/31, H01L 21/683, H01L 23/00, H01L 21/56

(54) **WAFER LEVEL CHIP SCALE PACKAGE WITH SIDEWALL PROTECTION**

(30) Priority: 24.05.2022 US 202263345057 P; 10.04.2023 US 202318132437
(71) Applicant: MediaTek Inc., Hsin-Chu 300 (TW)
(72) Inventor: CHEN, Yu-Tung, 30078 Hsinchu City (TW); TSAO, Pei-Haw, 30078 Hsinchu City (TW); FAN, Kuo-Lung, 30078 Hsinchu City (TW)
(74) Representative: Hoefer & Partner Patentanwälte mbB

(57) **Abstract**

A wafer level chip scale package (10) includes a bare silicon die (100) having an active surface (S1), a rear surface (S2) opposite to the active surface (S1), and a sidewall surface (SW) between the active surface (S1) and the rear surface (S2). The bare silicon die (100) includes a backside corner (BC) between the rear surface (S2) and the sidewall surface (SW). A plurality of pads (101) is disposed on the active surface (S1). A plurality of conductive elements (110) is disposed on the plurality of pads (101), respectively. A backside tape (220) is adhered to the rear surface (S2) by using an adhesive layer (210). The adhesive layer (210) and the backside tape (220) protrude beyond the sidewall surface (SW) of the bare silicon die (100). The adhesive layer (210) extends along the sidewall surface (SW) and wraps around the backside corner (BC).

## Description

### Cross Reference to Related Applications

This application claims the benefit of U.S. Provisional Application No. 63/345,057, filed on May 24th, 2022. The content of the application is incorporated herein by reference.

### Background

The present disclosure relates generally to the field of semiconductor packaging. More particularly, the present disclosure relates to an improved wafer level chip scale package (WLCSP) with sidewall protection.

As known in the art, a chip scale package (CSP) has overall package dimensions substantially equal to that of the silicon active device or die that is enclosed within the package. One such type of CSP is manufactured in wafer form and hence referred to as a wafer level CSP or WLCSP. A surface mount die is a WLCSP in which I/O contacts are in bump form and located on the active side of the die.

During manufacturing, WLCSP devices may be subjected to a number of processes and stress which may affect product yield and product reliability. For example, after singulation, the backside corner of a bare silicon die is easily damaged with chipping during the transportation and physical handling. As applications demand smaller and thinner die in WLCSP, the risk of die handling defects rise due to the absence of die sidewall protection.

### Summary

It is one object of the present disclosure to provide an improved wafer level chip scale package (WLCSP) with sidewall protection in order to solve the above-mentioned prior art deficiencies or shortcomings. A wafer level chip scale package according to the invention is defined in independent claim 1. The dependent claims define preferred embodiments thereof.

One aspect of the present disclosure provides a wafer level chip scale package including a bare silicon die having an active surface, a rear surface opposite to the active surface, and a sidewall surface between the active surface and the rear surface. The bare silicon die includes a backside corner between the rear surface and the sidewall surface. A plurality of pads is disposed on the active surface. A plurality of conductive elements is disposed on the plurality of pads, respectively. A backside tape is adhered to the rear surface by using an adhesive layer. The adhesive layer and the backside tape protrude beyond the sidewall surfaces of the bare silicon die. The adhesive layer extends along the sidewall surface and wraps around the backside corner.

Preferably, the bare silicon die is not encapsulated by a molding compound.

Preferably, the plurality of pads comprises solder pads or bump pads.

Preferably, the plurality of conductive elements comprises solder balls, solder bumps, metal bumps, micro-bumps or metal pillars.

Preferably, the adhesive layer and the backside tape protrude beyond the sidewall surfaces of the bare silicon die by a distance of 5-40 micrometers.

Preferably, a height of the adhesive layer on the sidewall surfaces of the bare silicon die is equal to or less than 25 micrometers.

Preferably, the adhesive layer only partially covers the sidewall surface of the bare silicon die.

Preferably, an included angle between an end surface of the adhesive layer and the sidewall surface of the bare silicon die is a right angle.

Preferably, an included angle between an end surface of the adhesive layer and the sidewall surface of the bare silicon die is an acute angle.

Preferably, an included angle between an end surface of the adhesive layer and the sidewall surface of the bare silicon die is an obtuse angle.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic top view of a wafer level chip scale package (WLCSP) according to an embodiment of the invention;
FIG. 2 is a bottom view of the WLCSP in FIG. 1;
FIG. 3 is a schematic, cross-sectional view taken along line I-I' in FIG. 1;
FIG. 4 is an enlarged partial view of the WLCSP according another embodiment of the invention;
FIG. 5 is an enlarged partial view of the WLCSP according still another embodiment of the invention; and
FIG. 6 to FIG. 10 are schematic diagrams showing an exemplary method for fabricating a WLCSP with sidewall protection according to an embodiment of the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

Handling defects such as, die corner stress, chipping and or die cracks can cause functional failures which may happen during the WLCSP processing or arise over the electronic product's life due to environment temperature or mechanic use stresses. WLCSP handling defects can occur at any step across the device process flow from WLCSP back end processes of dicing through tape and reel packing to the final surface mount of the WLCSP device on the product printed circuit board assembly (PCBA). After singulation, the backside corner of a bare silicon die is easily damaged with chipping during the transportation and physical handling. The present invention addresses this issue.

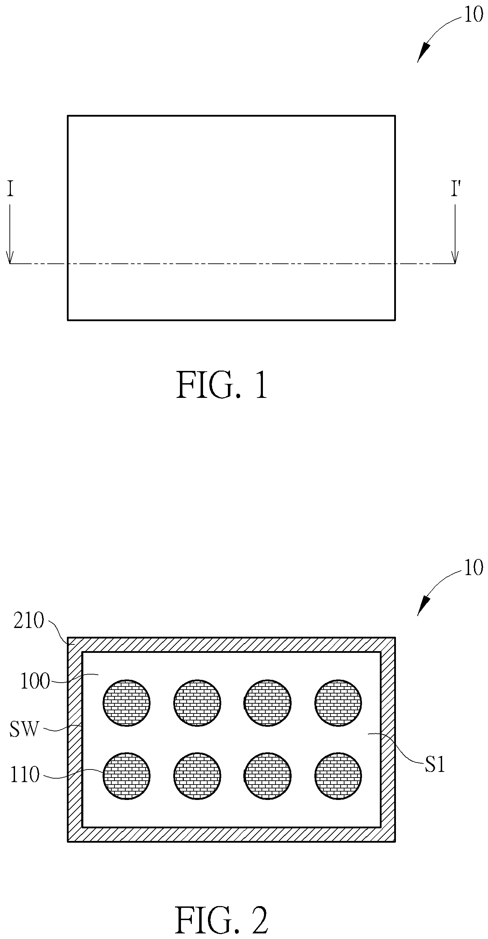

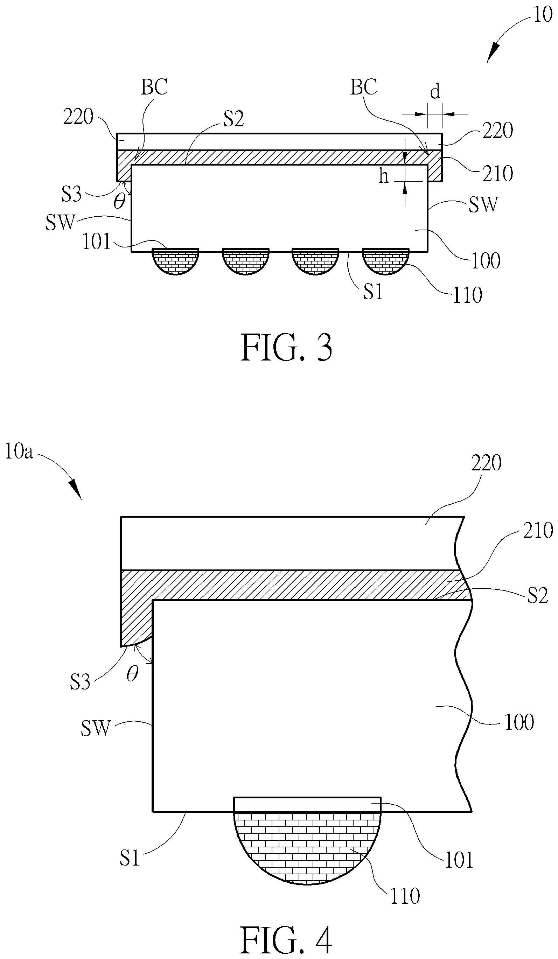

Please refer to FIG. 1 to FIG. 3. FIG. 1 is a schematic top view of a wafer level chip scale package (WLCSP) 10 according to an embodiment of the invention. FIG. 2 is a bottom view of the WLCSP 10 in FIG. 1. FIG. 3 is a schematic, cross-sectional view taken along line I-I' in FIG. 1. As shown in FIG. 1 to FIG. 3, the WLCSP 10 comprises a bare silicon die 100, which is not encapsulated by a molding compound. Preferably, the bare silicon die 100 comprises an active surface S1 and a rear surface S2 opposite to the active surface S1 and four sidewall surfaces SW between the active surface S1 and the rear surface S2. A backside corner BC is defined between the rear surface S2 and the sidewall surface SW.

Preferably, a plurality of pads 101 such as solder pads or bump pads is provided on the active surface S1. Preferably, a plurality of conductive elements 110 such as solder balls, solder bumps, metal bumps, micro-bumps or metal pillars may be disposed on the plurality of pads 101, respectively, for further connection. It is to be understood that dimension and number of the elements in the figures are for illustration purposes only. Preferably, the plurality of pads 101 may be re-distributed pads formed in a re-distribution layer (RDL) structure (not shown).

Preferably, a backside tape 220, such as a polyethylene terephthalate (PET) tape, is adhered to the rear surface S2 of the bare silicon die 100 by using an adhesive layer (or glue layer) 210 such as an epoxy resin layer. Preferably, the adhesive layer 210 and the backside tape 220 protrude beyond the sidewall surfaces SW of the bare silicon die 100 by a distance d, for example, d = 5-40 micrometers. Preferably, the adhesive layer 210 extends along the sidewall surfaces SW of the bare silicon die 100 and wraps around the backside corners BC. Preferably, a height h of the adhesive layer 210 on the sidewall surfaces SW of the bare silicon die 100 may equal to or less than 25 micrometers. The rest portion of the sidewall surface SW is not covered by the adhesive layer 210. The adhesive layer 210 around the backside corners BC functions as a sidewall protection that can prevent sidewall damage or chipping during the transportation and physical handling.

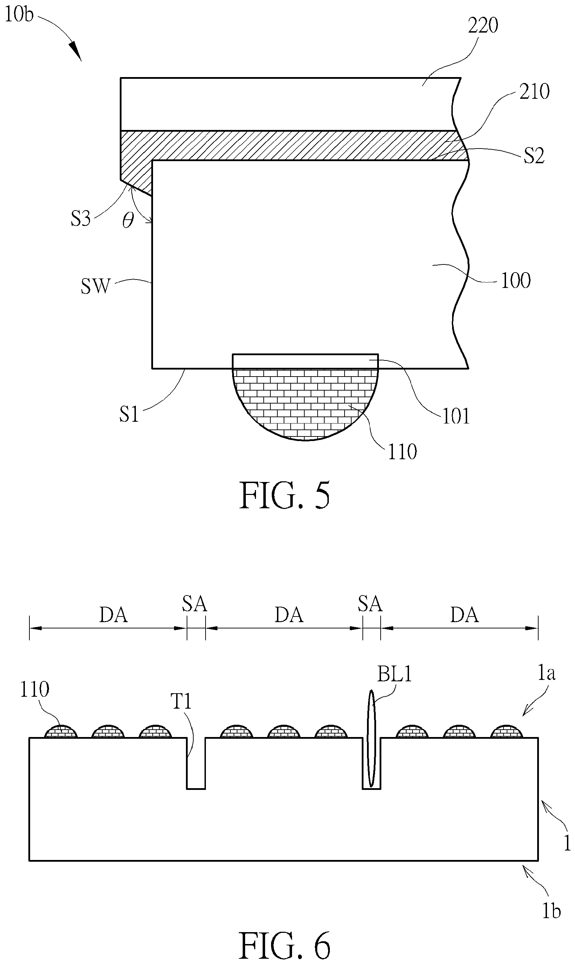

Preferably, the included angle Θ between the end surface S3 of the adhesive layer 210 and the adjacent sidewall surface SW of the bare silicon die 100 may be approximately a right angle. Alternatively preferably, as shown in FIG. 4, the included angle Θ between the end surface S3 of the adhesive layer 210 and the adjacent sidewall surface SW of the bare silicon die 100 of the WLCSP 10a may be an acute angle. Alternatively preferably, as shown in FIG. 5, the included angle Θ between the end surface S3 of the adhesive layer 210 and the adjacent sidewall surface SW of the bare silicon die 100 of the WLCSP 10b may be an obtuse angle.

FIG. 6 to FIG. 10 are schematic diagrams showing an exemplary method for fabricating a WLCSP with sidewall protection according to an embodiment of the invention, wherein like regions, elements or layers are designated by like numeral numbers or labels. As shown in FIG. 6, a thin wafer 1 having a front side 1a and a back side 1b is provided. Preferably, the thin wafer 1 comprises a plurality of die regions DA on the front side 1a. Integrated circuit elements are fabricated within each die region DA. Preferably, a plurality of conductive elements 110 such as solder balls, solder bumps, or metal bumps are disposed on the die regions DA on the front side 1a. The plurality of die regions DA separated by dicing lanes SA. The front side 1a is subjected to a pre-cut process BL1 to form half-cut trenches T1 into the front side 1a of the thin wafer 1 along the dicing lanes SA.

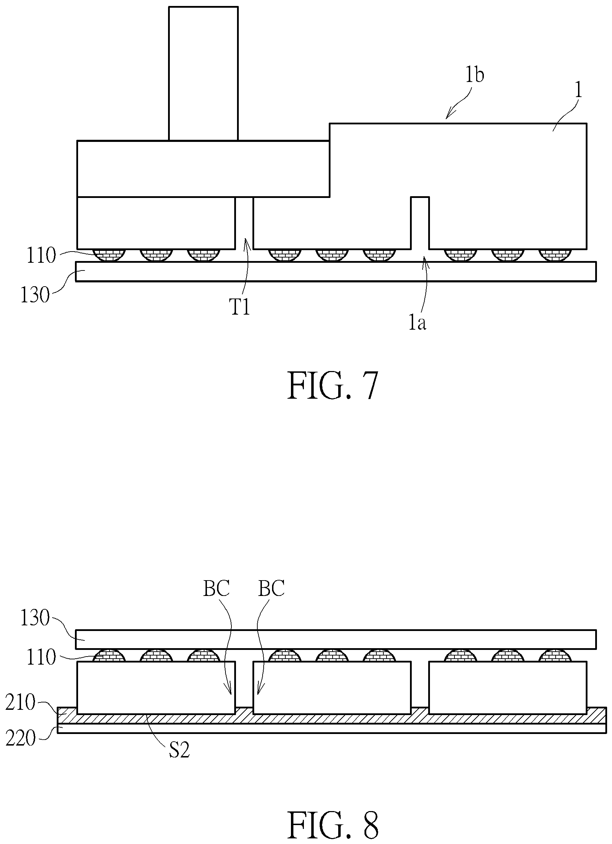

As shown in FIG. 7, a grinding tape 130 is temporarily adhered to the front side 1a of the thin wafer 1. The thin wafer 1 is then subjected to a wafer backside grinding to remove a portion of the thin wafer 1 from its back side 1b, thereby forming individual bare silicon die 10. The die singulation occurs when the wafer 1 is thinned below the level of the half-cut trenches T1.

As shown in FIG. 8, after the die singulation is completed, a backside tape 220 is adhered to the rear surface S2 of the bare silicon die 10 through the adhesive layer 210. At this point, the adhesive layer 210 may be squeezed into the dicing lanes SA and may partially cover the sidewall surface SW of the bare silicon die 10 around the backside corner BC.

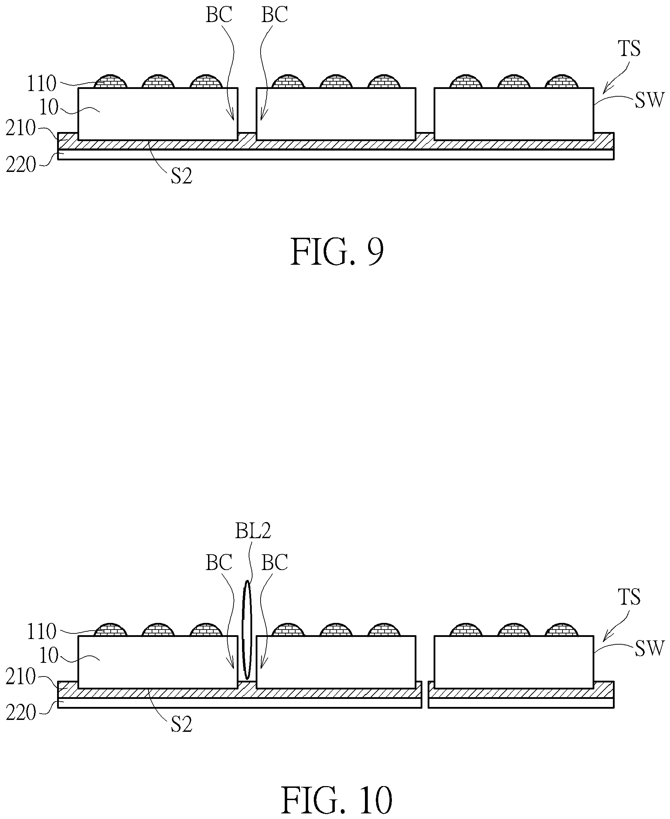

As shown in FIG. 9, after the backside tape 220 is laminated onto the bare silicon die 10, the grinding tape 130 is removed, thereby forming a temporary structure TS. The active surface S1 and the conductive elements 110 on the active surface S1 are revealed.

As shown in FIG. 10, the temporary structure TS is then subjected to a sawing process BL2 to cut through the adhesive layer 210 and the backside tape 220 along the dicing lanes SA. Preferably, the adhesive layer 210 extends along the sidewall surfaces SW of the bare silicon die 100 and wraps around the backside corners BC. Preferably, a height h of the adhesive layer 210 on the sidewall surfaces SW of the bare silicon die 100 may equal to or less than 25 micrometers. The rest portion of the sidewall surface SW is not covered by the adhesive layer 210. The adhesive layer 210 around the backside corners BC functions as a sidewall protection that can prevent sidewall damage or chipping during the transportation and physical handling.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A wafer level chip scale package (10), comprising:
a bare silicon die (100) comprising an active surface (S1), a rear surface (S2) opposite to the active surface (S1), and a sidewall surface (SW) between the active surface (S1) and the rear surface (S2), wherein the bare silicon die (100) comprises a backside corner (BC) between the rear surface (S2) and the sidewall surface (SW);
a plurality of pads (101) disposed on the active surface (S1);
a plurality of conductive elements (110) disposed on the plurality of pads (101), respectively; and
a backside tape (220) adhered to the rear surface (S2) by using an adhesive layer (210), wherein the adhesive layer (210) and the backside tape (220) protrude beyond the sidewall surface (SW) of the bare silicon die (100), and wherein the adhesive layer (210) extends along the sidewall surface (SW) and wraps around the backside corner (BC).

2. The wafer level chip scale package (10) according to claim 1, wherein the bare silicon die (100) is not encapsulated by a molding compound.

3. The wafer level chip scale package (10) according to claim 1 or 2, wherein the plurality of pads (101) comprises solder pads or bump pads.

4. The wafer level chip scale package (10) according to any one of claims 1 to 3, wherein the plurality of conductive elements (110) comprises solder balls, solder bumps, metal bumps, micro-bumps or metal pillars.

5. The wafer level chip scale package (10) according to any one of claims 1 to 4, wherein the adhesive layer (210) and the backside tape (220) protrude beyond the sidewall surface (SW) of the bare silicon die (100) by a distance (d) of 5-40 micrometers.

6. The wafer level chip scale package (10) according to any one of claims 1 to 5, wherein a height (h) of the adhesive layer (210) on the sidewall surface (SW) of the bare silicon die (100) is equal to or less than 25 micrometers.

7. The wafer level chip scale package (10) according to any one of claims 1 to 6, wherein the adhesive layer (210) only partially covers the sidewall surface (SW) of the bare silicon die (100).

8. The wafer level chip scale package (10) according to any one of claims 1 to 7, wherein an included angle (Θ) between an end surface (S3) of the adhesive layer (210) and the sidewall surface (SW) of the bare silicon die (100) is a right angle.

9. The wafer level chip scale package (10) according to any one of claims 1 to 7, wherein an included angle (Θ) between an end surface (S3) of the adhesive layer (210) and the sidewall surface (SW) of the bare silicon die (100) is an acute angle.

10. The wafer level chip scale package (10) according to any one of claims 1 to 7, wherein an included angle (Θ) between an end surface (S3) of the adhesive layer (210) and the sidewall surface (SW) of the bare silicon die (100) is an obtuse angle.
